# EUROPÄISCHE PATENTANMELDUNG

(11) **EP 1 800 862 A2**
(43) Veröffentlichungstag der Anmeldung: **27.06.2007**
(21) Anmeldenummer: 06026021.3
(22) Anmeldetag: 15.12.2006
(51) Int. Cl.: B41C 1/14

(54) **Verfahren und Vorrichtung zur Laserbelichtung eines Siebes zur Verwendung im Siebdruck**

(30) Priorität: 24.12.2005 DE 102005062217; 24.12.2005 DE 202005020198 U
(71) Anmelder: Lindthaler, Josef, 32547 Bad Oeynhausen (DE)
(72) Erfinder: Lindthaler, Josef, 32547 Bad Oeynhausen (DE)
(74) Vertreter: WALTHER, WALTHER & HINZ Patentanwälte - European Patent Attorneys

(57) **Zusammenfassung**

Gegenstand der Erfindung ist ein Verfahren zur Laserbelichtung eines Siebes (11), wobei nur ein Teil des Siebes (11) mit einer Nutzbelichtung (16) belegt ist. Ein Verfahren zur Laserbelichtung eines Siebes der eingangs genannten Art zu schaffen, bei dem eine Verschmutzung der Siebdruckvorrichtung verhindert wird, ohne das kostenintensive Maßnahmen erforderlich sind, wird dadurch erreicht, dass ein außerhalb der Nutzbelichtung (16) liegender Randbereich (18) des Siebes (11) ebenfalls belichtet wird.

## Beschreibung

Die vorliegende Erfindung betrifft ein Verfahren gemäß dem Oberbegriff des Anspruches 1 und eine Vorrichtung gemäß dem Oberbegriff des Anspruches 8.

Beim Siebdruck mit laserbelichteten Sieben wird das eigentliche Motiv, die sogenannte Nutzbelichtung, in der Regel in der Mitte des Siebes angeordnet. Hierzu wird der entsprechende Bereich mit einer lichtempfindlichen Emulsion belegt und anschließend mit einem Negativ vom gewünschten Motiv belichtet. Dabei verbindet sich die Emulsion an den belichteten Stellen mit dem Sieb und verbleibt dauerhaft auf dem Sieb. Die übrige Emulsion wird anschließend entfernt.

Das Sieb ist so dimensioniert, dass es deutlich größer als die eigentliche Nutzbelichtung ist, damit Motive unterschiedlicher Größe aufgebracht werden können und um beim späteren Siebdruck genügend Platz zum Auftragen der Farbe zu haben. Dabei kommt es vor, dass in dem außerhalb der Nutzbelichtung liegenden Randbereich ungewollt Farbe durch das Sieb hindurch tritt und so die gesamte Siebdruckvorrichtung verschmutzt. Um dies zu verhindern, wird der nicht belichtete Randbereich in einem eigenen Arbeitsschritt mühsam mit einem farbundurchlässigen Siebfüller bedeckt, der das Durchtreten von Farbe im Randbereich verhindert.

Aus der GB 1 517 291 A ist es bekannt, das Sieb mit einem lichtempfindlichen Klebstoff zu versehen, wobei der Bereich außerhalb der Nutzbelichtung ebenfalls Licht ausgesetzt wird, um diesen Klebstoff auf dem Sieb darauf zu fixieren.

Aus der EP 0 246 741 A2 ist es bekannt, das gesamte Sieb mit einer photoempfindlichen Emulsion zu versehen, welche nach Belichtung außer im Bereich der Nutzbelichtung aushärtet.

In beiden genannten Druckschriften erfolgt die Belichtung des Siebes mir herkömmlichen Lichtquellen und nicht über eine Laserbelichtung. Hierbei besteht die Gefahr, dass die eigentliche Nutzbelichtung durch Streulicht verfremdet wird. Außerdem ist eine solche Belichtung sehr aufwändig und zeitintensiv.

Davon ausgehend liegt der vorliegenden Erfindung die Aufgabe zu Grunde, ein Verfahren und eine Vorrichtung zur Laserbelichtung eines Siebes der eingangs genannten Art zu schaffen, bei dem die Randbelichtung zur Vermeidung einer Verschmutzung der Siebdruckvorrichtung sehr viel schneller und kostengünstiger erreicht wird.

Als technische Lösung dieser Aufgabe wird erfindungsgemäß ein Verfahren mit den Merkmalen des Anspruches 1 und eine Vorrichtung mit den Merkmalen des Anspruches 8 vorgeschlagen. Vorteilhafte Weiterbildungen dieses Verfahrens und dieser Vorrichtung sind den jeweiligen Unteransprüchen zu entnehmen.

Ein nach dieser technischen Lehre ausgeführtes Verfahren und eine nach dieser technischen Lehre ausgeführte Vorrichtung haben den Vorteil, dass durch die Belichtung auch des Randbereiches des Siebes eben auch dieser Teil des Siebes außerhalb der Nutzbelichtung durch belichten der dort aufgetragenen Emulsion mit einem farbundurchlässigen Auftrag versehen wird, so dass das gesamte Sieb ausgefüllt ist. Somit kann außerhalb der Nutzbelichtung keine Farbe durch das Sieb gelangen, so dass eine versehentliche Verschmutzung der Anlage vermieden wird. Folglich ist das separate Auftragen eines Siebfüller entbehrlich, was zu einer erheblichen Kostenersparnis führt.

Dabei erfolgt die Randbelichtung mittels einer mit einer Anzahl von Dioden bestückten Lichtleiste, während die Nutzbelichtung über einen aus dem Stand der Technik bekannten Laserbelichter erfolgt. Dies hat den Vorteil, dass die viel kostengünstigere Lichtleiste die Randbelichtung übernimmt, während der sehr teure Laserbelichter nur zur Nutzbelichtung eingesetzt wird. Somit erfolgt die Randbelichtung sehr kostengünstig.

Es hat sich als vorteilhaft erwiesen, diesen Randbereich derart vollständig, das heißt mit ausreichender Intensität, auszubelichten, dass die im Randbereich aufgetragene Emulsion im ausbelichteten Zustand einen farbundurchlässigen Auftrag bildet.

Ein weiterer Vorteil besteht darin, dass die Lichtleiste eine sehr viel höhere Lichtleistung als der Laserbelichter aufweist, so dass hiermit die Randbelichtung sehr viel schneller erfolgen kann. Folglich kann die Bearbeitung eines einzelnen Siebes in kürzerer Zeit erfolgen, was die Maschinen- und Bearbeitungskosten senkt.

In einer vorteilhaften Weiterbildung sind die Dioden einzeln ansteuerbar. Hierdurch ist es möglich einzelne Teile des Randbereiches aus zu belichten, ohne dass andere Teile des Siebes belichtet werden.

In einer besonders bevorzugten Ausführungsform wechseln sich die Lichtleiste und der Laserbelichter bei der Belichtung des Siebes ab. Dies hat den Vorteil, dass die Nutzbelichtung und die Randbelichtung in einem Arbeitsgang erfolgen können.

In einer vorteilhaften Ausführungsform sind in der Lichtleiste eine Anzahl UV-LED's, Dioden oder andere Lichtquellen untergebracht. Dabei werden vorzugsweise zwischen 10 und 200, idealerweise 54 solche LED's einge-setzt, um das Sieb über die gesamte Breite belichten zu können. Diese sehr kostengünstigen LED's, Dioden oder anderen Lichtquellen können im Falle eines Defekts einzeln ausgetauscht werden, was die Betriebs- und Reparaturkosten niedrig hält. Die Anzahl der UV-LED's, Dioden oder anderer Lichtquellen ist abhängig von dem gewünschten Abstrahlwinkel, der Lichtausbeute und der benötigten Lichtleistung, um das Sieb auszuhärten.

In einer besonders bevorzugten Ausführungsform ist die Lichtleiste durch ein lichtundurchlässiges Gehäuse umgeben, welches zum Sieb hin licht-durchlässig ist. Hierdurch wird vermieden, dass die Lichtleiste Streulicht aussenden, welches eine möglicherweise bereits erfolgte Nutzbelichtung beschädigen könnte. Das Streulicht wird insbesondere dadurch minimiert, dass das Gehäuse möglichst nah an das Sieb herangeführt wird, vorzugsweise wenn der Abstand nur 50 µm beträgt.

Zur Erhöhung der Lichtleistung und der Homoginität ist es vorteilhaft, die Innenseite des Gehäuses reflektierend auszubilden.

Bei der Dimensionierung des Gehäuses hat es sich als vorteilhaft erwiesen, die durchlässige Öffnung so auszubilden, dass eine Austrittsöffnung zwischen 10° und 15°, vorzugsweise 12° entsteht. Hierdurch wird eine ausreichend Belichtung erreicht, ohne dass unnötig viel Streulicht entsteht. Auch kann bei diesem Winkel eine relativ hohe Vorschubgeschwindigkeit eingestellt werden, so dass die Bearbeitungszeit deutlich reduziert werden kann.

Weitere Vorteile des erfindungsgemäßen Verfahrens und der erfindungsgemäßen Vorrichtung ergeben sich aus der beigefügten Zeichnung und den nachstehend beschriebenen Ausführungsformen. Ebenso können die vorstehend genannten und die noch weiter ausgeführten Merkmale erfindungsgemäß jeweils einzeln oder in beliebigen Kombinationen miteinander verwendet werden. Die erwähnten Ausführungsformen sind nicht als abschließende Aufzählung zu verstehen, sondern haben vielmehr beispielhaften Charakter. Es zeigen:
- Fig. 1a - d: eine schematische Darstellung einer ersten Ausführungsform einer Rand- und Nutzbelichtung eines Siebes zu verschiedenen Zeitpunkten;
- Fig. 2a - d: eine schematische Darstellung einer zweiten Ausführungsform einer Rand- und Nutzbelichtung eines Siebes zu verschiedenen Zeitpunkten;
- Fig. 3a - d: eine schematische Darstellung einer dritten Ausführungsform einer Rand- und Nutzbelichtung eines Siebes zu verschiedenen Zeitpunkten;
- Fig. 4: eine schematische dargestellte, geschnittene Seitenansicht einer vierten Ausführungsform einer erfindungsgemäßen Vorrichtung;
- Fig. 5: eine schematische dargestellte, geschnittene Seitenansicht einer fünften Ausführungsform einer erfindungsgemäßen Vorrichtung.

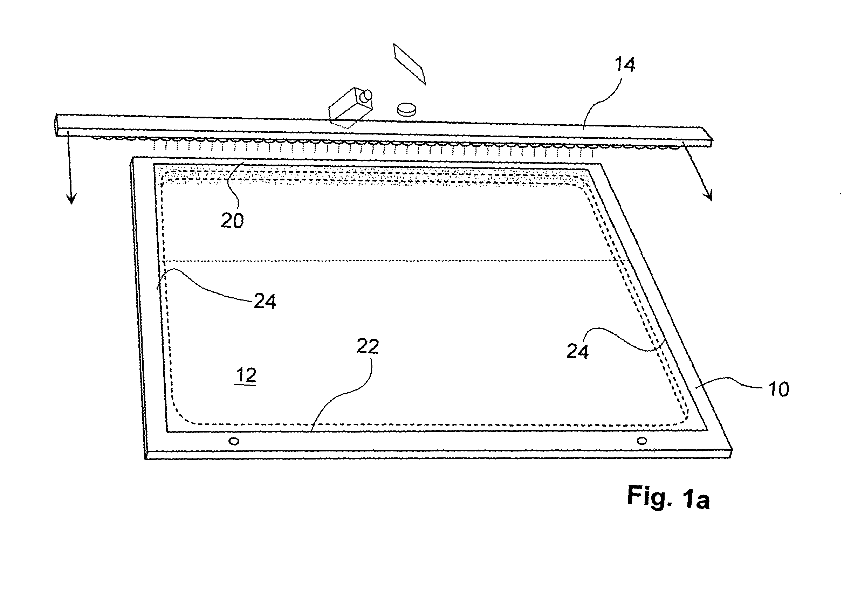

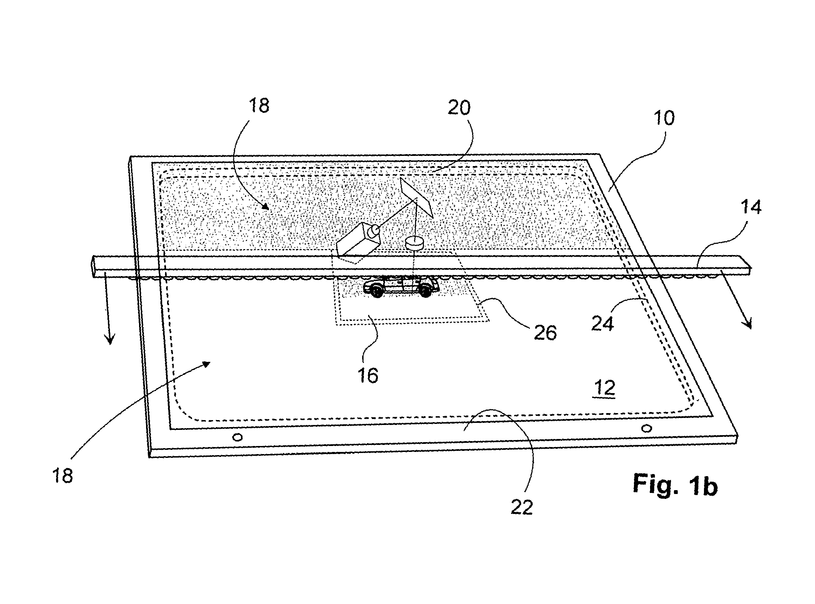

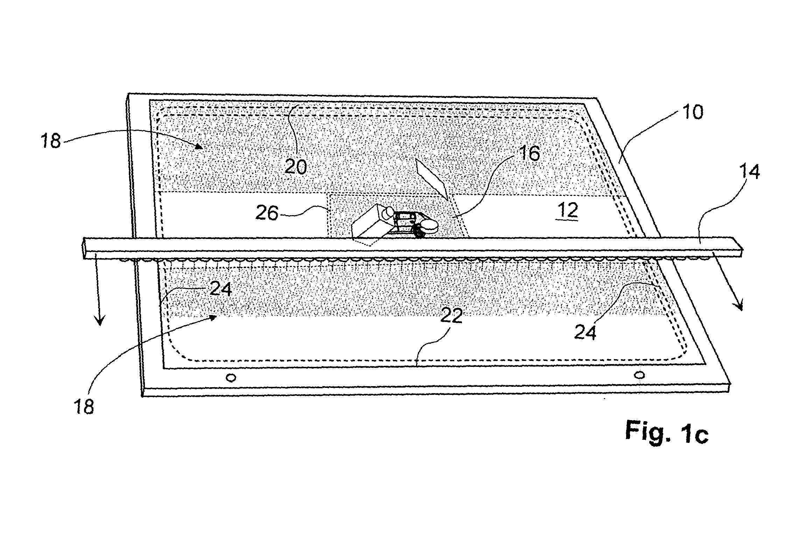

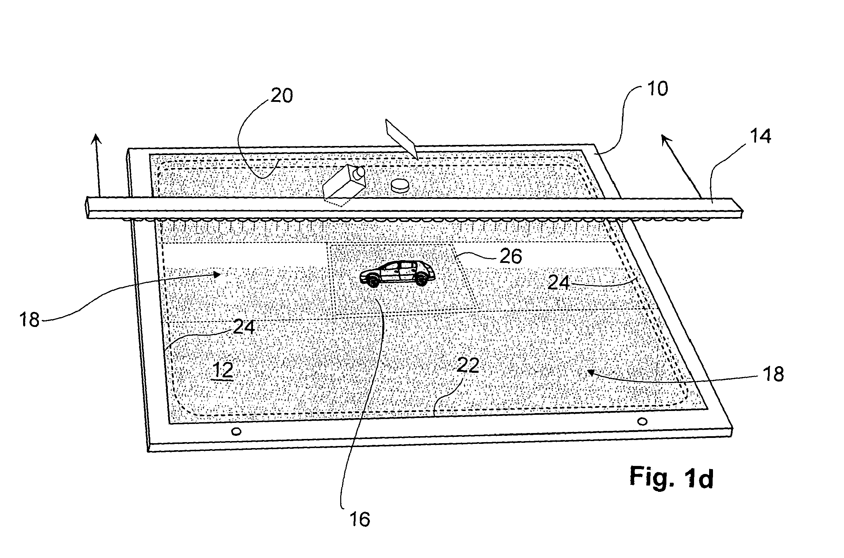

In den Fig. 1 a bis 1 d ist in schematischer Weise ein in einem Rahmen 10 gehaltenes und mit einer lichtempfindlichen Emulsion versehenes Sieb 11 dargestellt, welches von einem Laserbelichter 12 und einer Lichtleiste 13 überstrichen wird. Dabei sind der Laserbelichter 12 und die Lichtleiste 13 an einer gemeinsamen, verfahrbaren Brücke 14 gehalten. Die Lichtleiste 14 ist mit einer Anzahl von Dioden 15 bestückt, die einzeln ansteuerbar sind. Beim Überstreichen des Siebes 11 wird im Zentrum des Siebes 11 durch den Laserbelichter 12 eine Nutzbelichtung 16 durchgeführt, während der außerhalb der Nutzbelichtung 16 liegende Randbereich 18 des Siebes 11 durch die Lichtleiste 13 ebenfalls belichtet wird. Hierzu im Einzelnen:

Die Brücke 14 überstreicht das Sieb 11 zusammen mit dem Laserbelichter 12 und der Lichtleiste 13 zweimal (hin und zurück). Dabei beginnt die Brücke 14 an einem ersten Rand 20 des Siebes 11 und bewegt sich zu einem zweiten Rand 22 des Siebes 11, der dem ersten Rand gegenüber liegt. Während sich die Brücke 14 vom ersten Rand 20 bis hin zum Beginn der Nutzbelichtung 16 bewegt ist die Lichtleiste 13 eingeschaltet und der Laserbelichter 12 ausgeschaltet, wie Fig. 1 a zu entnehmen ist. In dieser Phase kann sich die Brücke 14 mit einer sehr hoher Geschwindigkeit bewegen, da die Dioden eine ausreichend hohe Leistung aufweisen, um den Randbereich 18 auch bei einer hohen Geschwindigkeit der Brücke 14 ausreichend zu belichten. Am Rand der Nutzbelichtung 16 angekommen, wird die Lichtleiste 13 ausgeschaltet, der Laserbelichter 12 eingeschaltet und die Geschwindigkeit der Brücke 14 derart verlangsamt, dass der Laserbelichter 12 die Nutzbelichtung in an sich bekannter Weise ausführen kann, wie Fig. 1 b zu entnehmen ist. Nach ausgeführter Nutzbelichtung 16 wird der Laserbelichter 12 wieder abgeschaltet und die Lichtleiste 13 eingeschaltet, um den Bereich des Randbereiches 18 zwischen der Nutzbelichtung 16 und einem zweiten Rand 22 des Siebes auszubelichten, wie Fig. 1 c zu entnehmen ist. Dabei bewegt sich die Brücke 14 wieder mit erhöhter Geschwindigkeit.

Auf ihrem Rückweg, also beim zweiten Überstreichen des Siebes 11, werden dann die Bereiche des Randbereiches 18 zwischen der Nutzbelichtung 16 und den Seitenrändern 24 des Siebes 12 ausbelichtet. Dabei werden nur diejenigen Dioden 15 eingeschaltet, die über dem Randbereich 18 angeordnet sind und diejenigen Dioden, die über der Nutzbelichtung 16 angeordnet sind bleiben ausgeschaltet, um eine weitere, unerwünschte Belichtung der Nutzbelichtung 16 zu vermeiden.

Ein derart belichtetes Sieb 11 wird anschließend in an sich bekannter Weise von der nicht ausgehärteten Emulsion befreit, so dass der Teil des Siebes farbundurchlässig wird, durch den später keine Farbe hindurchtreten soll. Da nunmehr auch der Randbereich 18 belichtet ist, wird dieser Randbereich 18 automatisch ebenfalls mit der ausgehärteten Emulsion versehen, so dass hierzu kein eigenständiger Arbeitsschritt mehr erforderlich ist und so dass eine Verschmutzung der Siebdruckvorrichtung durch versehentlich im Randbereich 18 hindurchtretende Farbe vermieden wird.

Im Übergang von der Nutzbelichtung 16 zur Randbelichtung 18 ist ein sogenannter Lichtrand 26 ausgebildet, der sowohl durch die Nutzbelichtung 16, als auch durch die Randbelichtung 18 belichtet wird.

Es versteht sich, dass der Randbereich so stark ausbelichtet wird, dass eine farbundurchlässige Abdeckung des Randbereiches erreicht wird.

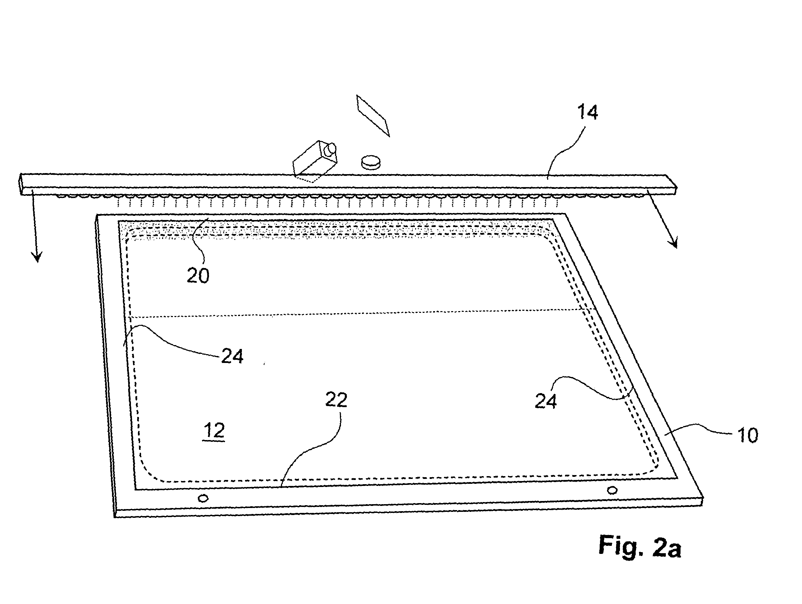

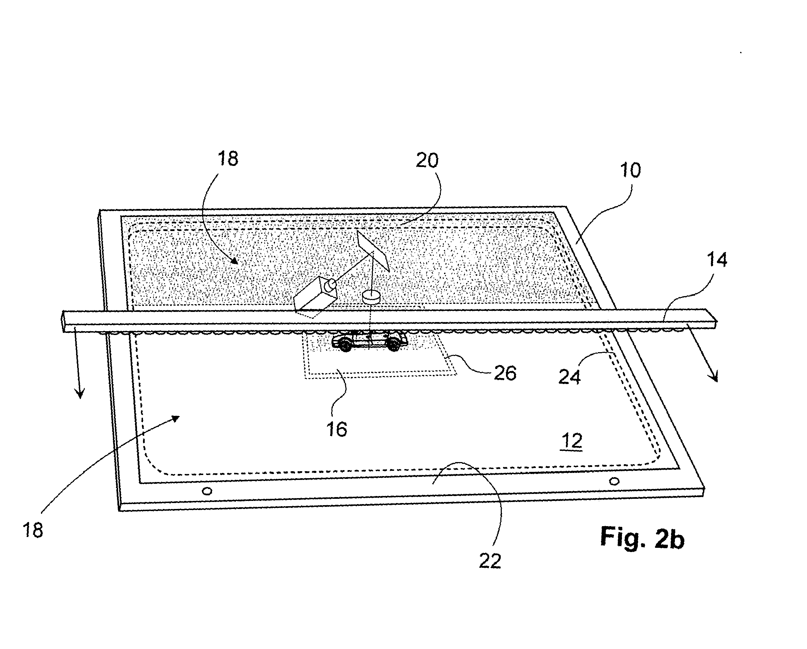

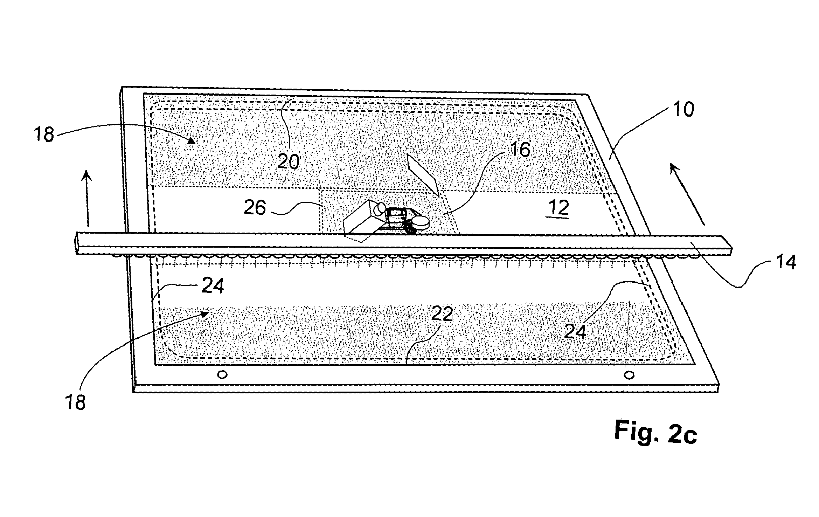

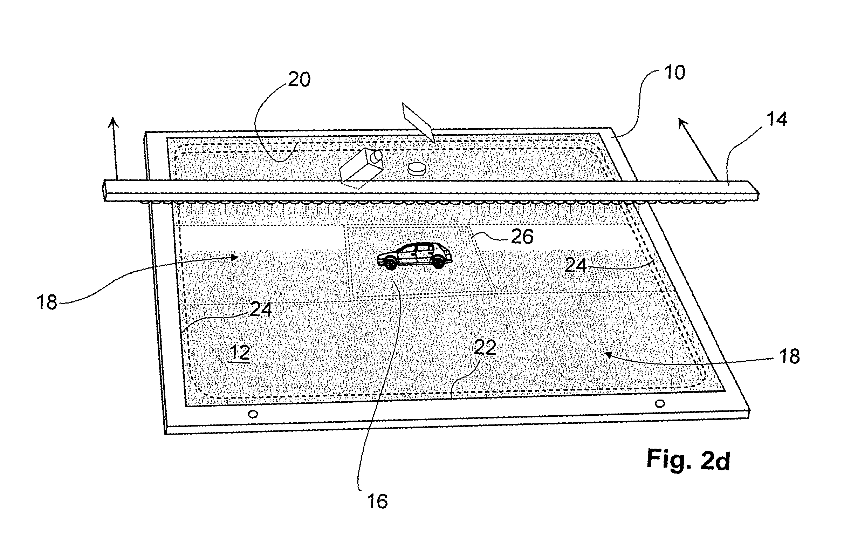

Die in den Figuren 2a bis 2d dargestellte zweite Ausführungsform unterscheidet sich von der in den Figuren 1 a bis 1 d dargestellten ersten Ausführungsform lediglich dadurch, dass nach Beendigung der Nutzbelichtung 16 sowohl die Lichtleiste 13, als auch der Laserbelichter 12 ausgeschaltet bleiben und die Brücke 14 schnell zum zweiten Rand 22 bewegt wird, ohne eine weitere Belichtung aus zu führen. Erst auf dem Rückweg wird die Lichtleiste 13 aktiviert und belichtet den Randbereich 18, während sich die Brücke 14 vom zweiten Rand 22 zum ersten Rand 20 zurück bewegt, wie Fig 2 c zu entnehmen ist.

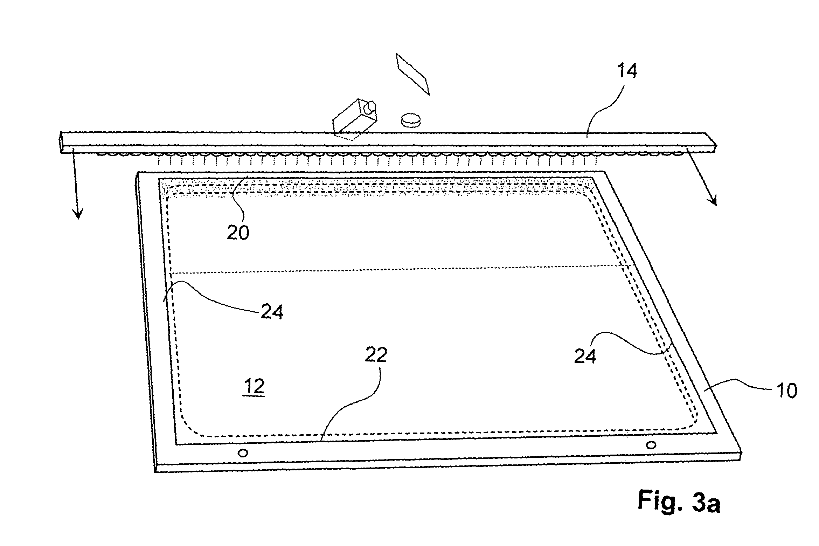

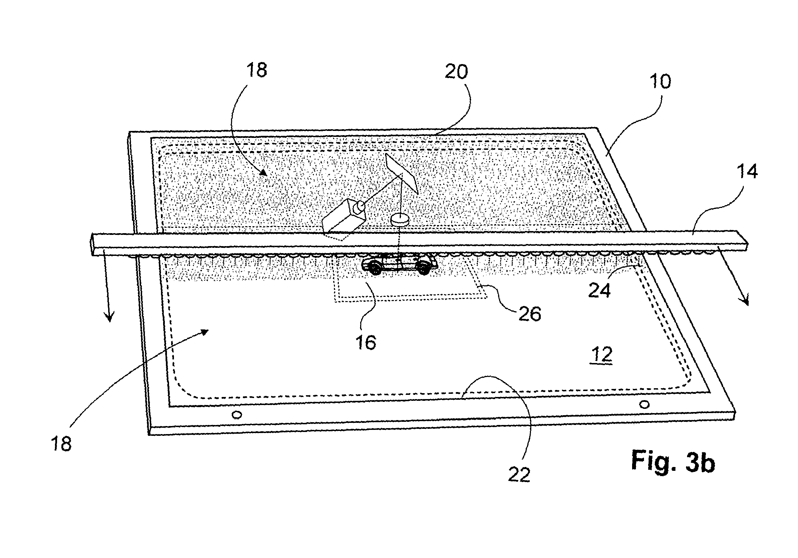

Die in den Figuren 3a bis 3d dargestellte dritte Ausführungsform unterscheidet sich von der in den Figuren 1 a bis 1 d dargestellten ersten Ausführungsform lediglich dadurch, dass während der Nutzbelichtung 16 durch den Laserbelichter 12 gleichzeitig auch einige der Dioden 15 der Lichtleiste 13 aktiviert sind, um den Randbereich 18 zwischen der Nutzbelichtung 16 und den Seitenrändern 24 aus zu belichten, wie Fig. 3b zu entnehmen ist. Weil die Brücke 14 sich während der Nutzbelichtung 16 langsamer bewegt, als bei einer reinen Randbelichtung 18, brauchen die Dioden 15 in dieser Phase nur mit verminderter Leistung betrieben werden, um eine ausreichende Ausbelichtung zu erreichen.

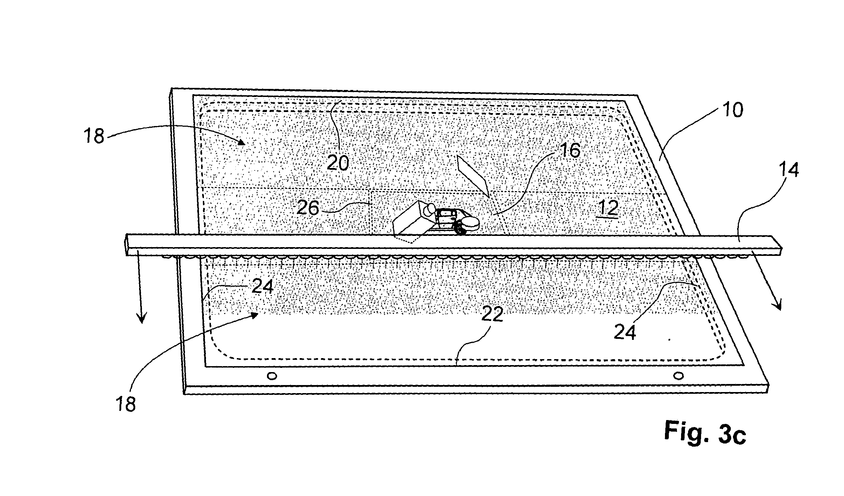

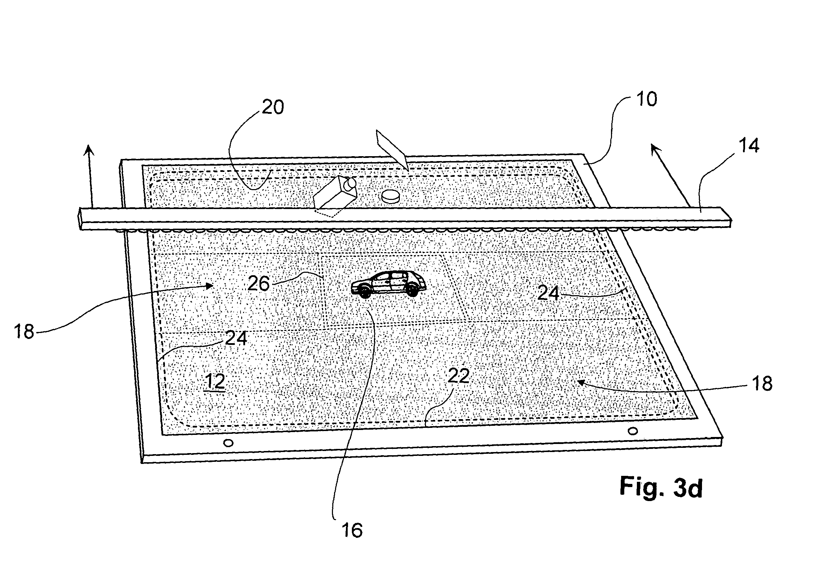

Da in dieser Ausführungsform sowohl die Randbelichtung 18, als auch die Nutzbelichtung 16 während dem ersten Überfahren des Siebes 11 abgeschlossen wird, kann die Brücke 14 auf ihrem Rückweg mit einer höheren Geschwindigkeit zurück gefahren werden, wie Fig. 3 d zu entnehmen ist.

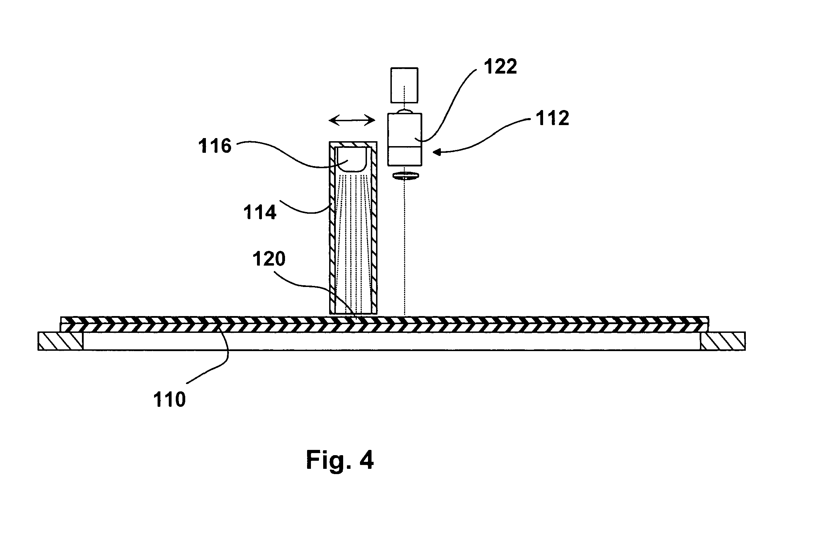

Die in Fig. 4 dargestellte vierte Ausführungsform einer erfindungsgemäßen Vorrichtung zum Belichten eines Siebes zur Verwendung im Siebdruck um-fasst eine linear über einem zu belichtendem Sieb 110 verfahrbare Lichtleiste 112. Diese Lichtleiste 112 umfasst ein Gehäuse 114 und nebeneinander entlang einer virtuellen Linie 154 im Gehäuse 114 untergebrachte LED's 116, die einzeln gesteuert werden können.

Das Gehäuse 114 ist an drei Seiten lichtundurchlässig und besitzt an seiner dem Sieb 110 zugewandten Seite einen Schlitz 120, der etwa 1 mm breit ist. Die Innenseite des Gehäuses 114 ist reflektierend ausgebildet, so dass das von den LED's ausgesendete Licht nahezu vollständig zum Sieb 110 geleitet wird.

Die Lichtleiste 112 ist direkt neben einem Laserbelichter 122 angebracht und wird gemeinsam mit diesem über dem Sieb 110 hin und her bewegt.

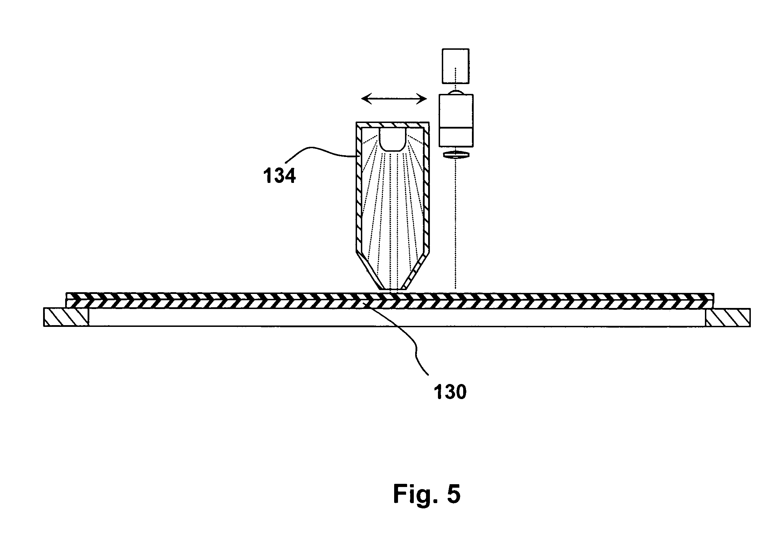

Die in Fig. 5 dargestellte fünfte Ausführungsform unterscheidet sich von der in Fig. 4 dargestellten Ausführungsform lediglich dadurch, dass das Gehäuse 134 an seiner dem Sieb 130 zugewandten Seite konisch verjüngend ausgebildet ist.

In einer anderen, hier nicht dargestellten Ausführungsform ist die Lichtleiste fest montiert und das Sieb wird entsprechend unter die Lichtleiste hin und her bewegt.

### Bezugszeichenliste:

- 10: Rahmen
- 11: Sieb
- 12: Laserbelichter
- 13: Lichtleiste
- 14: Brücke
- 15: Dioden
- 16: Nutzbelichtung
- 18: Randbereich
- 20: erster Rand des Siebes
- 22: zweiter Rand des Siebes
- 24: Seitenrand
- 26: Lichtrand
- 110, 130: Sieb
- 112: Lichtleiste
- 114, 134: Gehäuse
- 116: LED
- 120: Schlitz
- 122: Laserbelichter

## Patentansprüche

1. Verfahren zur Laserbelichtung eines Siebes (12), wobei nur ein Teil des Siebes (12) mit einer Nutzbelichtung (16) belegt ist,
**dadurch gekennzeichnet,**
**dass** ein außerhalb der Nutzbelichtung (16) liegender Randbereich (18) des Siebes (12) ebenfalls belichtet wird und dass die Randbelichtung mittels einer eine Anzahl Dioden aufweisenden Lichtleiste (13) erfolgt, während die Nutzbelichtung mittels eines an sich bekannten Laserbelichters (12) erfolgt.

2. Verfahren nach Anspruch 1,
**dadurch gekennzeichnet,**
**dass** die Lichtleistung der Lichtleiste (13) höher als die Lichtleistung des Laserbelichters (12) ist.

3. Verfahren nach einem der vorangehenden Ansprüche,
**dadurch gekennzeichnet,**
**dass** die Dioden (15) einzeln ansteuerbar sind.

4. Verfahren nach einem der vorangehenden Ansprühe,
**dadurch gekennzeichnet,**
**dass** die Lichtleiste (13) zusammen mit dem Laserbelichter (12) zunächst das Sieb (11) von einem ersten Rand (20) ausgehend zu einem zweiten Rand (22) hin überstreicht, und anschließend das Sieb (12) in umgekehrter Richtung vom zweiten Rand (22) hin zum ersten Rand (20) überstreicht, wobei die Lichtleiste (13) zunächst dem Randbereich (18) vom ersten Rand (20) bis zur Nutzbelichtung (16) hin ausbelichtet, anschließend der Laserbelichter (12) die Nutzbelichtung (16) aufbringt, wobei danach die Lichtleiste (13) den Randbereich (18) von der Nutzbelichtung (16) zum zweiten Rand (22) hin ausbelichtet, und wobei diejenigen Dioden (15) der Lichtleiste (13) auf ihrem Rückweg den Randereich (18) zwischen der Nutzbelichtung (16) und den Seitenrändern (24) ausbelichten, die über diesem Randbereich (18) angeordnet sind.

5. Verfahren nach einem der Ansprühe 1 bis 3,
**dadurch gekennzeichnet,**
**dass** die Lichtleiste (13) zusammen mit dem Laserbelichter (12) zunächst das Sieb (11) von einem ersten Rand (20) ausgehend zu einem zweiten Rand (22) hin überstreicht, und anschließend das Sieb (12) in umgekehrter Richtung vom zweiten Rand (22) hin zum ersten Rand (20) überstreicht, wobei die Lichtleiste (13) zunächst dem Randbereich (18) vom ersten Rand (20) bis zur Nutzbelichtung (16) hin ausbelichtet, anschließend der Laserbelichter (12) die Nutz-belichtung (16) aufbringt, wobei danach die Lichtleiste (13) und der Laserbelichter (12) in ausgeschaltetem Zustand an den zweiten Rand (22) gefahren werden, während beim zweiten Überstreichen des Siebes (11) die Lichtleiste (13) vom zweiten Rand (22) ausge-hend eingeschaltet ist, um den Randbereich (18) vom zweiten Rand (22) zur Nutzbelichtung (16) zum zweiten Rand (22) hin aus zu belichten, und wobei diejenigen Dioden (15) der Lichtleiste (13) auf ihrem Rückweg den Randereich (18) zwischen der Nutzbelichtung (16) und den Seitenrändern (24) ausbelichten, die über diesem Randbereich (18) angeordnet sind.

6. Verfahren nach einem der Ansprühe 1 bis 3,
**dadurch gekennzeichnet,**
**dass** die Lichtleiste (13) zusammen mit dem Laserbelichter (12) zunächst das Sieb (11) von einem ersten Rand (20) ausgehend zu einem zweiten Rand (22) hin überstreicht, und anschließend das Sieb (12) in umgekehrter Richtung vom zweiten Rand (22) hin zum ersten Rand (20) überstreicht, wobei die Lichtleiste (13) zunächst den Randbereich (18) vom ersten Rand (20) bis zur Nutzbelichtung (16) hin ausbelichtet, wobei anschließend der Laserbelichter (12) die Nutzbelichtung (16) aufbringt, während diejenigen Dioden (15) der Lichtleiste (13) ausgeschaltet werden, die sich über der Nutzbelich-tung (16) befinden, so dass der Bereich zwischen der Nutzbelich-tung (16) und dem Seitenrand (24) ausbelichtet wird, wobei danach die Lichtleiste (13) den Randbereich (18) von der Nutzbelichtung (16) zum zweiten Rand (22) hin ausbelichtet, und wobei sowohl die Lichtleiste (13), als auch der Laserbelichter (12) ausgeschaltet bleiben, während diese vom zweiten Rand (22) zum ersten Rand (20) zurück geführt werden.

7. Verfahren nach Anspruch 6,
**dadurch gekennzeichnet,**
**dass** die Dioden (15) der Lichtleiste (13) nur mit verminderter Leistung betreiben werden, während der Randbereich (18) zwischen der Nutzbelichtung (16) und dem Seitenrand (24) ausbelichtet wird.

8. Vorrichtung zur Laserbelichtung eines Siebes zur Verwendung im Siebdruck, mit einer Siebhaltevorrichtung zur präzisen Aufnahme eines vorzugsweise gerahmten Siebes (110, 130) und mit einem gegenüber dem Sieb (110, 130) verfahrbar angebrachten Laserbelichter (122),
**gekennzeichnet durch**,
eine ebenfalls gegenüber dem Sieb (110, 130) verfahrbar angebrachte Lichtleiste (112) zur Belichtung desjenigen Bereiches des Siebes (110, 130), der vom Laserbelichter (122) nicht belichtet wird.

9. Vorrichtung nach Anspruch 8,
**dadurch gekennzeichnet,**
**dass** die Lichtleiste (112) eine Anzahl LED's (116), Dioden oder anderer Lichtquellen umfasst.

10. Vorrichtung nach einem der Ansprüche 8 oder 9,
**dadurch gekennzeichnet,**
**dass** die LED's (116), Dioden oder anderen Lichtquellen einzeln ansteuerbar sind.

11. Vorrichtung nach einem der Ansprüche 8 bis 10,
**dadurch gekennzeichnet,**
**dass** die Lichtleiste (112) von einem lichtundurchlässigen Gehäuse (114, 134) umgeben ist, welches zum Sieb (110, 130) hin lichtdurchlässig gestaltet ist.

12. Vorrichtung nach Anspruch 11,
**dadurch gekennzeichnet,**
**dass** das Gehäuse (114, 134) bis unmittelbar an das Sieb heranreicht.

13. Vorrichtung nach einem der Ansprüche 11 oder 12,
**dadurch gekennzeichnet,**
**dass** der Abstand des Gehäuses (114, 134) zum Sieb (110, 130) zwischen 20 µm und 80 µm, vorzugsweise 50 µm beträgt.

14. Vorrichtung nach einem der Ansprüche 8 bis 13,
**dadurch gekennzeichnet,**
**dass** die Innenseite des Gehäuses (114, 134) reflektierend ausgebildet ist.

15. Vorrichtung nach einem der Ansprüche 8 bis 13,
**dadurch gekennzeichnet,**
**dass** die Lichtleiste (112) an ihrer dem Sieb (110, 130) zugewandten Seite einen lichtdurchlässigen Schlitz (120) aufweist.

16. Vorrichtung nach Anspruch 15,
**dadurch gekennzeichnet,**
**dass** sich der Schlitz (120) über die gesamte Breite des Siebes (110, 130) erstreckt und eine lichte Weite zwischen 0,5 mm und 2 mm, vorzugsweise 1 mm aufweist.

17. Vorrichtung nach einem der Ansprüche 8 bis 16,
**dadurch gekennzeichnet,**
**dass** in der Lichtleiste (112) zwischen 10 und 200, vorzugsweise 54 LED's (116) oder Dioden angebracht sind.

18. Vorrichtung nach einem der Ansprüche 8 bis 17,
**dadurch gekennzeichnet,**
**dass** jedes LED (116) oder jede Diode eine Austrittsöffnung zwischen 10° und 15°, vorzugsweise 12° besitzt.

19. Vorrichtung nach einem der Ansprüche 8 bis 18,
**dadurch gekennzeichnet,**
**dass** das Gehäuse (14, 34) zum Sieb (10, 30) hin konisch verjüngend ausgebildet ist.
